# EUROPÄISCHE PATENTSCHRIFT

(11) **EP 1 912 268 B1**
(45) Veröffentlichungstag und Bekanntmachung des Hinweises auf die Patenterteilung: **01.01.2020**
(21) Anmeldenummer: 06021123.2
(22) Anmeldetag: 09.10.2006
(51) Int. Cl.: H01L 51/54, H01L 51/56

(54) **Verfahren zur räumlichen Strukturierung der Leuchtdichte von lichtermittierenden organischen Halbleiterbauelementen, danach hergestelltes Halbleiterbauelement und Verwendung desselben**
Method for spatial structuring the emission density of an OLED, semiconductor device obtained by the method and its use
Méthode de structuration spatiale de l'émission d'une OLED, dispositif organique électroluminescent obtenu par cette méthode, et son usage

(43) Veröffentlichungstag der Anmeldung: 16.04.2008
(73) Patentinhaber: Novaled GmbH, 01099 Dresden (DE)
(72) Erfinder: Zeika, Olaf, 01187 Dresden (DE); Birnstock, Jan, 01187 Dresden (DE); Limmert, Michael, 01277 Dresden (DE); Vehse, Martin, 01324 Dresden (DE)
(74) Vertreter: Bittner, Thomas L.

(56) Entgegenhaltungen:
- EP-A1- 1 837 926
- EP-A1- 1 837 927
- EP-A2- 1 271 669
- WO-A-2006/081780
- WO-A1-02/082560
- WO-A2-01/99208
- US-A1- 2003 111 666
- US-A1- 2004 033 641
- US-A1- 2004 220 332
- US-A1- 2006 066 222
- ONODA ET AL: "The maskless dye diffusion technique-A proposal of patterning techniques for polymer light-emitting device" CURRENT APPLIED PHYSICS, NORTH-HOLLAND, Bd. 6, Nr. 5, September 2006 (2006-09), Seiten 887-890, XP005519691 ISSN: 1567-1739
- LI FENGHONG ET AL: "Acridine orange base as a dopant for n doping of C60 thin films", JOURNAL OF APPLIED PHYSICS, AMERICAN INSTITUTE OF PHYSICS. NEW YORK, US, vol. 100, no. 2, 31 July 2006 (2006-07-31) , pages 23716-023716, XP012089470, ISSN: 0021-8979, DOI: DOI:10.1063/1.2219374
- YOKOI H ET AL: "Photochemical Doping of TCNQ by Photoinduced Electron Transfer and C-C Cleavage of Radical Cation", CHEMISTRY LETTERS, CHEMICAL SOCIETY OF JAPAN, JP, vol. 3, 1 May 2003 (2003-05-01), pages 241-242, XP002355670, ISSN: 0366-7022
- MURAMATSU T ET AL: "PREPARATION AND PROPERTIES OF A NOVEL HETEROCYCLIC DISPRIO COMPOUND, 3,10-DIAZA-N,N-DIMETHYLDISPIROÄ5.0.5.3ÜPEN TADECA-1,4,8,11-TETRAENE", CHEMISTRY LET, CHEMICAL SOCIETY OF JAPAN, JAPAN, vol. 25, no. 2, 1 January 1996 (1996-01-01), page 151/152, XP008068093, ISSN: 0366-7022, DOI: 10.1246/CL.1996.151

## Beschreibung

Die vorliegende Erfindung betrifft ein Verfahren zur räumlichen Strukturierung der Leuchtdichte von lichtemittierenden organischen Halbleiterbauelementen, ein danach hergestelltes Halbleiterbauelement und dessen Verwendung.

Es ist bekannt, organische Halbleiter durch Dotierung hinsichtlich ihrer elektrischen Eigenschaften, insbesondere ihrer elektrischen Leitfähigkeit, zu verändern, wie dies auch bei anorganischen Halbleitern, wie Siliciumhalbleitern, der Fall ist. Hierbei wird durch Erzeugung von Ladungsträgern im Matrixmaterial eine Erhöhung der zunächst recht niedrigen Leitfähigkeit sowie je nach Art des verwendeten Dotanden eine Veränderung im Fermi-Niveau des Halbleiters erreicht. Eine Dotierung führt hierbei zu einer Erhöhung der Leitfähigkeit von Ladungstransportschichten, wodurch ohmsche Verluste verringert werden, und zu einem verbesserten Übergang der Ladungsträger zwischen Kontakten und organischer Schicht. Im Falle organischer Leuchtdioden (OLEDs) bedeutet dies eine erheblich geringere Betriebsspannung. Im Folgenden wird der Begriff "Dotierung" in dem Sinne gebraucht, dass Ladungsträger in eine Matrix eingebracht werden, die zur Elektronenabgabe (n-Dotand) oder -aufnahme (p-Dotand) befähigt sind.

EP 1 837 926 A1 beschreibt Radikale und dessen Dimere sowie die Verwendung derselben zur Herstellung organischer halbleitender Materialien und zur Herstellung von Bauelementen, die diese Verbindungen umfassen.

F. Li, A. Werner et al., J. Phys. Chem. B 2004, demonstrierten die Dotierung von C₆₀ nach Einbringen von Leuko-Kristallviolett und anschließender Bestrahlung mit UV-Licht. Eine erhöhte Leitfähigkeit wurde ermittelt.

Von H. Yokoi et al., Chem. Lett. 1999, ist eine photochemische Dotierung von Tetracyanochinondimethan (TCNQ) durch lichtinduzierten Elektronentransfer bekannt. Dabei wird zunächst ein Elektron auf die Matrix (TCNQ) übertragen und anschließend ein irreversibler C-C-Bindungsbruch des nun oxidierten n-Dotanden durchgeführt. Yokoi hat die Bedeutung dieser Beobachtung für elektronische Anwendungen bereits erkannt und eine strukturierte Photodotierung in Aussicht gestellt. Gravierende Nachteile seiner Systeme aber waren zum einen sehr lange Belichtungszeiten von mehreren Stunden, was im Normalfall unerwünschte Nebenreaktionen und damit Leistungseinbußen und ggf. Funktionsunfähigkeit bei technischen Anwendungen zur Folge hätte, sowie zum anderen die Anwendbarkeit nur bei starken Akzeptormolekülen als Matrix, was wiederum eine Anwendbarkeit, insbesondere bei OLEDs, ausschließt.

Das Einbringen von Dotanden zur Veränderung der Leitfähigkeit in einen organischen Halbleiter, sei es aus homogener Lösung oder durch Aufdampfen, erfolgt in der Regel in homogener Verteilung. Als Konsequenz davon sind alle Bereiche der Schicht in annähernd gleichem Maße leitend. Für die Anwendung in organischen Leuchtdioden (OLEDs) bedeutet dies eine gleichmäßige Leuchtdichte über ihre gesamte Fläche. Strukturierungen, beispielsweise Symbole, Schriftzüge, Helligkeitsverläufe und dergleichen, lassen sich so nur mit erhöhtem Aufwand erreichen: entweder durch entsprechend konstruierte oder zusammengesetzte OLEDs sowie durch Abdeckung auszublendender Bereiche nach deren Herstellung. Letzteres ist gerade bei großflächigen Abdeckungen wenig effizient.

Der vorliegenden Erfindung liegt die Aufgabe zugrunde, die aus dem Stand der Technik bekannten Nachteile zu überwinden und insbesondere ein Verfahren zur räumlichen Strukturierung der Leuchtdichte von lichtemittierenden organischen Halbleiterbauelementen bereitzustellen, mit dem diese Halbleiterbauelemente in einfacher, beständiger und kostengünstiger Weise hergestellt werden können.

Die Aufgabe wird gelöst gemäß dem Gegenstand des unabhängigen Anspruchs 1. Bevorzugte Ausführungsformen ergeben sich aus den Unteransprüchen.Die Aufgabe wird erfindungsgemäß gelöst durch Verfahren zur räumlichen Strukturierung der Leuchtdichte von lichtemittierenden organischen Halbleiterbauelementen, umfassend die Schritte:
(i) Herstellen eines lichtemittierenden organischen Bauelements umfassend eine elektronenleitende Schicht aus organischem Matrixmaterial und homogen darin eingebetteten n-Dotandenprecursorn;
(iia) Bestrahlen eines oder mehrerer Teilbereiche des Bauelements zur Spaltung der n-Dotandenprecursor im bestrahlten Bereich in n-Dotanden
wobei der n-Dotand ein heterocyclisches Radikal oder Diradikal ist und der n-Dotandenprecursor ein Dimer eines heterocyclischen Radikals oder Diradikals, ein Oligomer eines heterocyclischen Radikals oder Diradikals, ein Polymer eines heterocyclischen Radikals oder Diradikals, eine Dispiroverbindung eines heterocyclischen Radikals oder Diradikals oder ein Polycyclus eines heterocyclischen Diradikals ist und die Strukturen der n-Dotandenprecursor ausgewählt werden aus den folgenden Formeln 2, 4 und 6 und/oder n-Dotanden ausgewählt werden aus den folgenden Formeln 1, 3, 5, 7, 8a, 8b, 8c, 10 und 11 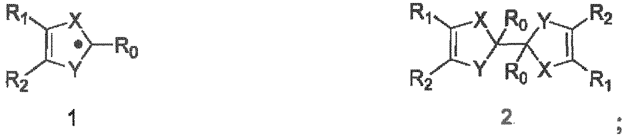 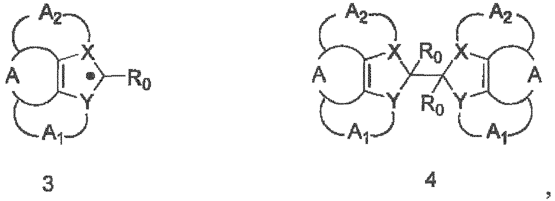 wobei die Strukturen 3 und 4 eine oder mehrere cyclische Verknüpfungen A und/oder A₁ und/oder A₂ aufweisen, wobei A, A₁ und A₂ carbocyclische, heterocyclische und/oder polycyclische Ringsysteme sein können, die substituiert oder unsubstituiert sein können; 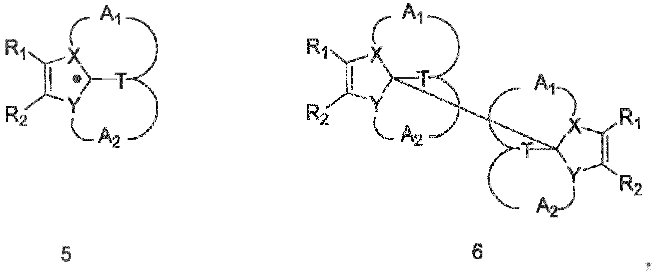 wobei A₁ und A₂ einzeln oder gemeinsam vorliegen können und A₁ und A₂ wie für Strukturen 3 und 4 definiert sind und T = CR₂₂, CR₂₂R₂₃, N, NR₂₁, O oder S ist; 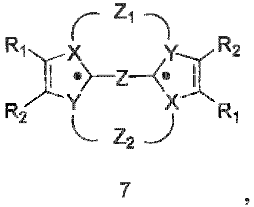 wobei Struktur 7 eine oder mehrere Brückenverbindungen Z und/oder Z₁ und/oder Z₂ aufweist, und Z, Z₁ und Z₂ unabhängig ausgewählt sein können aus Alkyl, Alkenyl, Alkinyl, Cycloalkyl, Sililyl; Alkylsililyl, Diazo, Disulfid, Heterocycloalkyl, Heterocyclyl, Piperazinyl, Dialkylether, Polyether, primärem Alkylamin, Arylamin und Polyamin, Aryl und Heteroaryl; 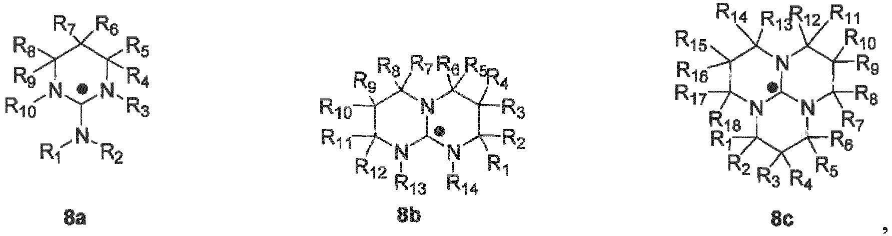 wobei in den Strukturen 8a - 8c die Ringgröße je Heterocyclus von 5 - 7 Atomen variieren kann; 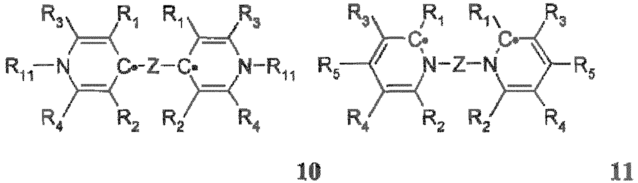 wobei X, Y = O, S, N, NR₂₁, P, oder PR₂₁ ist; Z wie oben definiert ist; R₀₋₁₉, R₂₁, R₂₂ und R₂₃ unabhängig ausgewählt sind aus, substituiert oder unsubstituiert, Aryl, Heteroaryl, Heterocyclyl, Diarylamin, Diheteroarylamin, Dialkylamin, Heteroarylalkylamin, Arylalkylamin, H, Cycloalkyl, Halogencycloalkyl, Heterocycloalkyl, Alkyl, Alkenyl, Alkinyl, Trialkylsilyl, Triarylsilyl, Halogen, Styryl, Alkoxy, Aryloxy, Thioalkoxy, Thioaryloxy, Sililyl und Trialkylsilylalkinyl, oder R₀₋₁₉, R₂₁, R₂₂ und R₂₃, allein oder in Kombination, Teil eines Ringsystems, (hetero)aliphatisch oder (hetero)aromatisch, sind,
wobei das Bestrahlen in Schritt (iia) durchgeführt wird mit elektromagnetischer Strahlung, und
wobei nicht das gesamte Bauelement homogen bestrahlt wird.

Für die Bestrahlung der Dotandenprecursor kann eine große Anzahl unterschiedlicher Lichtquellen eingesetzt werden. Zur Aktivierung der Dotandenprecursor ist sichtbares Licht des UV/Vis-Bereichs von etwa 200 bis 800 nm, bevorzugt 300-520 nm, besonders bevorzugt 350-450 nm geeignet.

Im Halbleiterbauelement der vorliegenden Erfindung können Dotandenprecursor und Dotanden auch gleichzeitig vorliegen. Diese Kombination ergibt sich beispielsweise bei unvollständiger Aktivierung der Dotandenprecursor. Bei Deaktivierung der Dotanden wird derzeit angenommen, daß dadurch die Dotandenprecursor nicht zurückgebildet werden.

Bevorzugt ist, daß das Bestrahlen in dem Schritt (iia) durch Abdeckung der nicht zu bestrahlenden Teilbereiche durchgeführt wird, vorzugsweise durch Anordnung einer oder mehrerer Schattenmasken auf dem Bauelement.

Erfindungsgemäß ist vorgesehen, daß das Bestrahlen in Schritt (iia) durchgeführt wird mit elektromagnetischer Strahlung, insbesondere sichtbarem Licht, UV-Licht oder IR-Licht, beispielsweise Laserlicht. Ferner können andere fokussierte Lichtquellen, die für lithographische Anwendungen geeignet sind, verwendet werden.

Besonders bevorzugt ist, daß die Aktivierung in Schritt (iia) irreversibel ist.

Erfindungsgemäß ist vorgesehen, daß die Strukturen der Dotandenprecursor oder Dotanden ausgewählt werden aus den folgenden Formeln 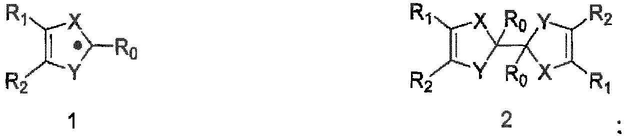 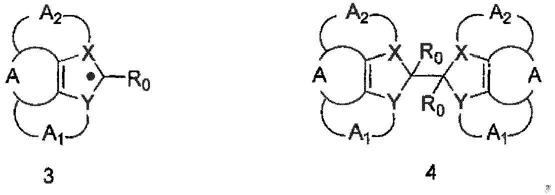 wobei die Strukturen 3 und 4 eine oder mehrere cyclische Verknüpfungen A und/oder A₁ und/oder A₂ aufweisen, wobei A, A₁ und A₂ carbocyclische, heterocyclische und/oder polycyclische Ringsysteme sein können, die substituiert oder unsubstituiert sein können; 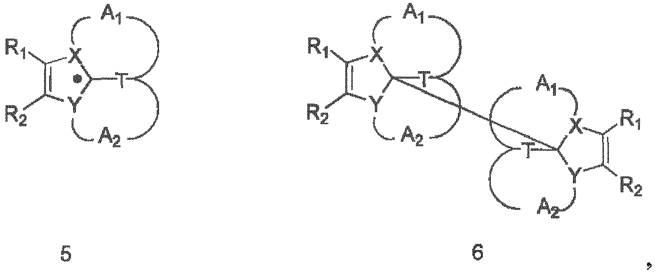 wobei A₁ und A₂ einzeln oder gemeinsam vorliegen können und A₁ und A₂ wie für Strukturen 3 und 4 definiert sind und T = CR₂₂, CR₂₂R₂₃, N, NR₂₁, O oder S ist; 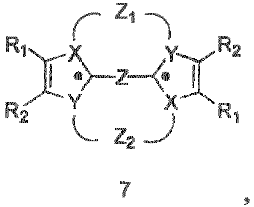 wobei Struktur 7 eine oder mehrere Brückenverbindungen Z und/oder Z₁ und/oder Z₂ aufweist, und Z, Z₁ und Z₂ unabhängig ausgewählt sein können aus Alkyl, Alkenyl, Alkinyl, Cycloalkyl, Sililyl; Alkylsililyl, Diazo, Disulfid, Heterocycloalkyl, Heterocyclyl, Piperazinyl, Dialkylether, Polyether, primärem Alkylamin, Arylamin und Polyamin, Aryl und Heteroaryl; 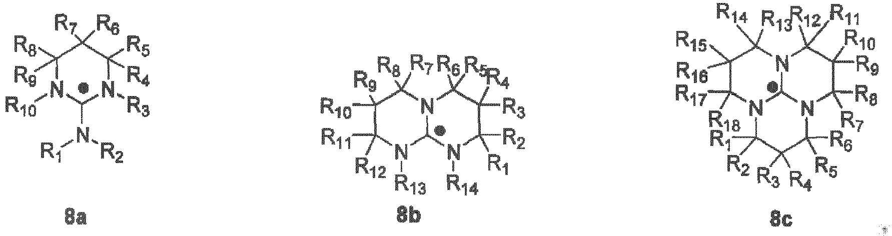 wobei in den Strukturen 8a - 8c die Ringgröße je Heterocyclus von 5 - 7 Atomen variieren kann; 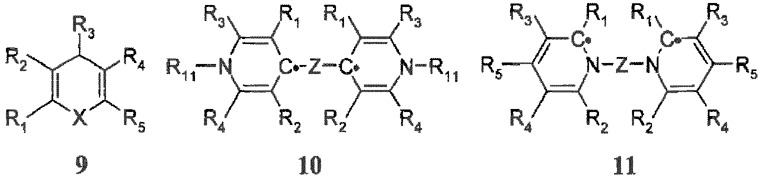 wobei X, Y = O, S, N, NR₂₁, P, oder PR₂₁ ist; Z wie oben definiert ist; R₀₋₁₉, R₂₁, R₂₂ und R₂₃ unabhängig ausgewählt sind aus, substituiert oder unsubstituiert, Aryl, Heteroaryl, Heterocyclyl, Diarylamin, Diheteroarylamin, Dialkylamin, Heteroarylalkylamin, Arylalkylamin, H, F Cycloalkyl, Halogencycloalkyl, Heterocycloalkyl, Alkyl, Alkenyl, Alkinyl, Trialkylsilyl, Triarylsilyl, Halogen, Styryl, Alkoxy, Aryloxy, Thioalkoxy, Thioaryloxy, Sililyl und Trialkylsilylalkinyl, oder R₀₋₁₉, R₂₁, R₂₂ und R₂₃, allein oder in Kombination, Teil eines Ringsystems, (hetero)aliphatisch oder (hetero)aromatisch, sind.

Insbesondere ist es vorteilhaft, daß A, A₁ und A₂ ausgewählt werden aus substituierten oder nicht-substituierten, aromatischen und heteroaromatischen Ringsystemen, vorzugsweise Benzo-, Naphtho-, Thiophen-, Furan-, Thiazol-, Imidazol-, Oxazol-, Thiadiazol-, Pyrazin-, Thiopyran-, Dithiin-, Phthalsäureimid- und Dithiazol-Resten, wobei eine oder mehrere Substituenten vorliegen können, die ausgewählt sind aus R₀ - R₁₉, R₂₁, R₂₂ und R₂₃.

Auch kann vorgesehen sein, daß Z, Z₁ und Z₂ ausgewählt werden aus Piperazinyl und Alkyl bzw. Cycloalkyl.

Günstig ist auch, daß der Dotand ausgewählt wird aus den folgenden Strukturen: 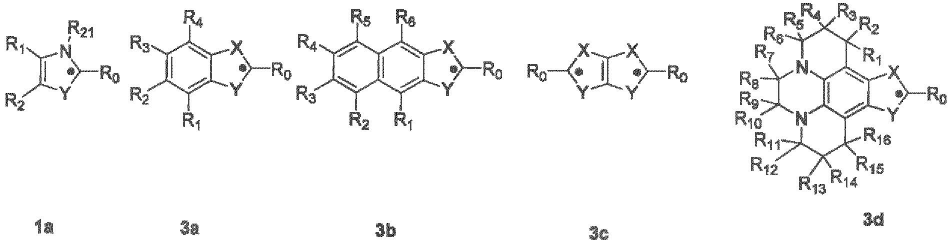 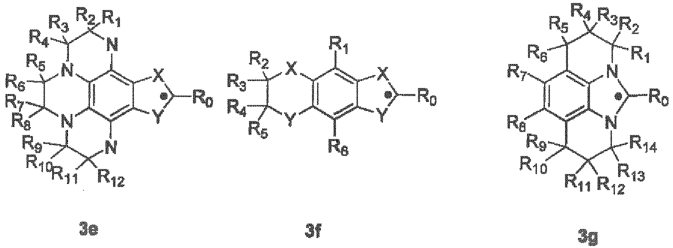 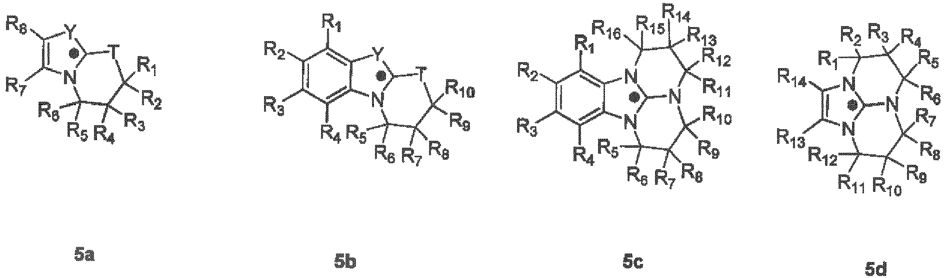 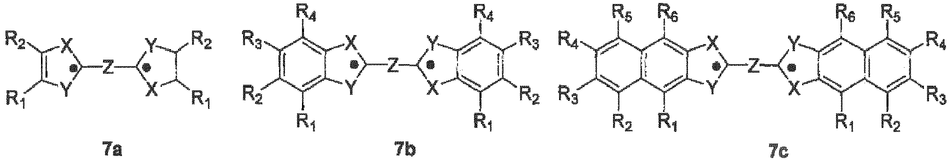 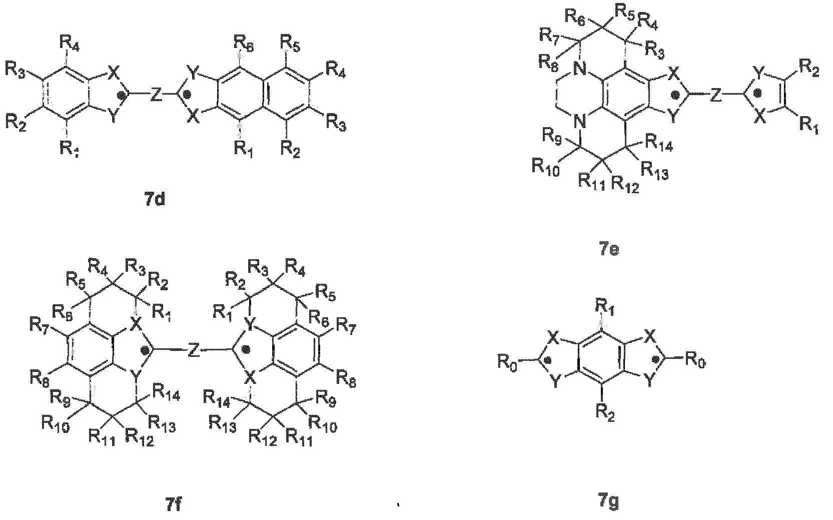 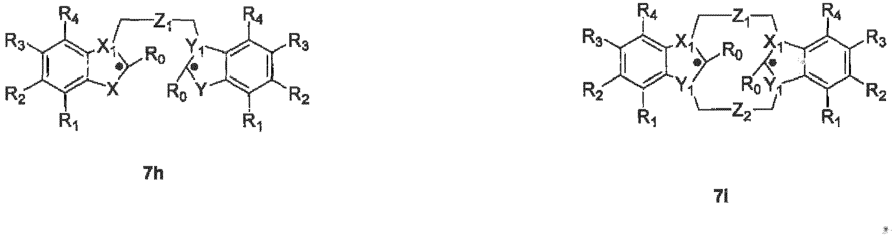 wobei X₁, Y₁ = N oder P ist.

Zweckmäßig ist ferner, daß R₀₋₁₉, R₂₁, R₂₂ und R₂₃ ausgewählt werden aus, substituiert oder nicht substituiert Phenyl, Biphenyl, Naphthyl, Anthranyl, Thienyl, Imidazolyl, Pyrrolyl, Thiazolyl, Oxazolyl, Thiadiazolyl, Piperidyl, Pyrrolidyl, Morpholyl und Thiomorpholyl.

Auch wird vorgeschlagen, daß R₀₋₁₉, R₂₁, R₂₂ und R₂₃ ausgewählt werden aus, Alkyl, Cykloalkyl, Dialkylamin, Diarylamin, Alkoxy, Aryloxy, Thioaryl, Thioalkoxy, Perfluoralkyl.

Bevorzugt ist, daß der Polycylus ein Tricylus ist.

Auch können bevorzugt zur elektronenleitenden Schicht Photoinitiatoren zugesetzt werden, vorzugsweise Ketone, wie Phenone.

Ferner wird ein lichtemittierendes organisches Halbleiterbauelement mit räumlicher Strukturierung der Leuchtdichte beschrieben, das nach einem erfindungsgemäßen Verfahren erhältlich ist, bevorzugt eine organische Leuchtdiode.

Schließlich kann ein lichtemittierendes organisches Halbleiterbauelement als Logo, Hinweisschild, dekorative Applikation, Namensschild, Barcode, Plakat, Reklametafel, Leuchtzug für Schaufenster oder Leuchtmittel für Wohnräume verwendet werden.

Erfindungsgemäß wurde überraschend festgestellt, daß organische Halbleiterbauelemente mit räumlicher Strukturierung der Leuchtdichte auf einfache und effiziente Weise hergestellt werden können, indem diese Bauelemente nach ihrer eigentlichen Herstellung gezielt bestrahlt werden, um eine räumliche Strukturierung der Leuchtdichte zu ermöglichen. Dabei werden nur Teilbereiche des Halbleiterbauelements, nicht jedoch das gesamte Element bestrahlt. Die elektronenleitende Schicht des organischen Halbleiterbauelements kann aus Matrixmaterial und darin im wesentlichen homogen eingebetteten n-Dotandenprecursorn hergestellt werden.

Bei Bestrahlung lediglich ausgewählter Teilbereiche dieses Halbleiterbauelements werden die Dotandenprecursor durch Bestrahlung aktiviert und können nunmehr als übliche Dotanden in der elektronenleitenden Schicht, wie es hinlänglich bekannt ist, wirken.

Mit dem erfindungsgemäßen Verfahren können standardisierte Halbleiterbauelemente mit geringem Aufwand hergestellt und insbesondere leicht nach Kundenwünschen angepaßt werden.

Erfindungsgemäß kann insofern durch die Bestrahlung die Luminanz-Strom-Spannungs-Charakteristik, insbesondere von PIN-OLEDs, gezielt zur Aktivierung leuchtender Bereiche beeinflußt werden.

Eine nachträgliche (photochemische) Reaktion, wie sie im erfindungsgemäßen Verfahren erfolgt, beeinflußt die grundlegenden Kenndaten in definierten Bereichen eines organischen Halbleiterbauelements, wie einer OLED: die Erhöhung bzw. Erniedrigung der Leitfähigkeit einer organischen halbleitenden Schicht erzeugt Domänen erhöhter bzw. verminderter Leuchtstärke bei gleichbleibender Betriebsspannung einer OLED. Um dies zu erreichen, werden chemische Verbindungen eingesetzt, deren Dotiervermögen und Aktivierungsschwelle technischen Anwendungen genügen.

Die große Attraktivität dieses lithographischen Verfahrens besteht darin, daß diese so strukturierten Bauteile immer noch hoch effizient sind. Dies läßt sich am leichtesten an einem Ersatzschaltbild verdeutlichen: im Prinzip entspricht das strukturierte OLED-Bauteil einer Parallelschaltung aus einer effizienten, aktiven sowie einer inaktiven Diode. Die inaktive Diode hat in Vorwärtsrichtung einen Widerstand, der etwa um einen Faktor 10-100 oder mehr größer ist als derjenige der aktiven Diode. Das bedeutet aber auch, daß nach den Kirchoffschen Gesetzen nur ein Bruchteil des Stroms über den inaktiven Teilbereich der OLED abfließt. Die Stromdichte im aktiven Teilbereich ist um einen Faktor 10-100 oder mehr höher. Dabei wird der weitaus überwiegende Teil der zugeführten elektrischen Energie auch tatsächlich in den Bereichen des Bauteils umgesetzt, die Licht emittieren. Eine hohe Leistungseffizienz des Bauteils ist die Folge.

Die n-Dotandenprecursoren bzw. n-Dotanden sind oben bereits erwähnt worden. Der bevorzugte Dotiermechanismus besteht darin, daß beispielsweise eine geeignete Verbindung photolytisch in zwei energiereiche Radikale gespalten wird, welche aufgrund ihres äußerst negativen Redoxpotentials ihr Elektron auf die umgebende Matrix übertragen. In den belichteten Bereichen liegen als Reaktionsprodukte dann sehr stabile Kationen neben Radikalanionen der Matrix vor, in den unbelichteten Bereichen verbleiben Dotandenprecursor und Matrix unverändert. Dieser Elektronentransfer ist unter den Bedingungen in einer OLED irreversibel.

Alternativ kann eine geeignete Verbindung erst ein Elektron an die umgebende Matrix abgeben. Das dabei entstandene Radikalkation zerfällt anschließend in eine sehr stabile Endstufe und in ein weiteres Radikal, welches ebenfalls als Dotand wirkt.

Eine freie Diffusion der Ladungsträger außerhalb bestrahlter Bereiche wird nicht beobachtet.

### Matrixmaterialien

Als n-dotierbare Matrixmaterialen können unter anderen Quinolinatokomplexe, beispielsweise des Aluminiums oder anderer Hauptgruppenmetalle, wobei der Quinolinatoligand auch substituiert sein kann, eingesetzt werden. Insbesondere kann das Matrixmaterial Tris(8-hydroxy-quinolinato)-aluminium sein. Auch andere Aluminiumkomplexe mit O- und/oder N-Donoratomen können gegebenenfalls eingesetzt werden. Gebräuchliche Matrixmaterialien sind auch Zinkphthalocyanin (ZnPc) oder Zinktetraphenylporphyrin (ZnTPP), um nur einige Vertreter der Phthalocyanin- bzw. Porphyrinkomplexe zu nennen.

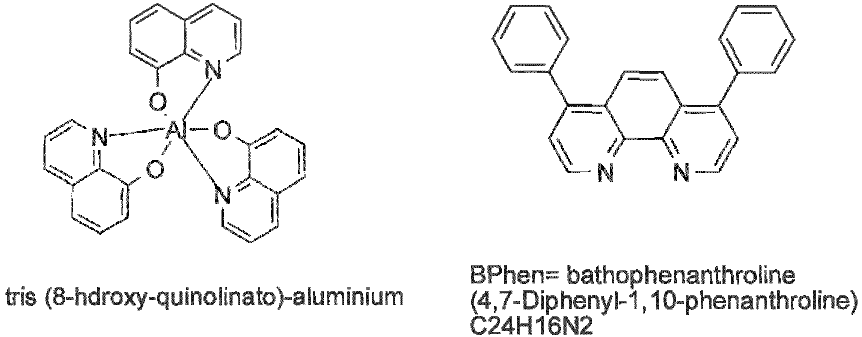

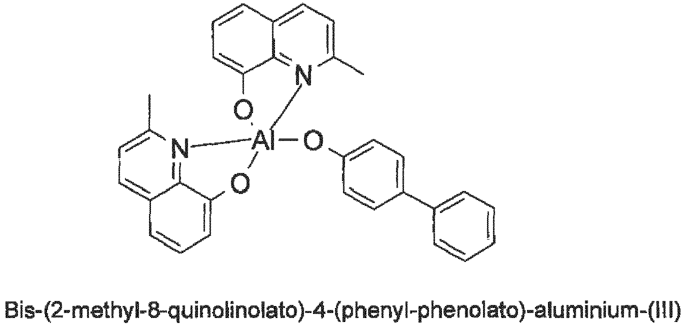

Die Quinolinatokomplexe können beispielsweise einen, zwei oder drei Quinolinatoliganden enthalten, wobei die anderen Liganden vorzugsweise mit O- und/oder N-Donoratomen an das Zentralatom komplexieren, wie beispielsweise obenstehender Al-Komplex.

Als Matrixmaterial können auch Phenanthroline eingesetzt werden, die substituiert oder unsubstituiert sein können, insbesondere Aryl-substituiert, beispielsweise Phenyl- oder Naphthyl-substituiert. Insbesondere kann Bathophenanthrolin (Bphen) als Matrixmaterial eingesetzt werden.

Als Matrixmaterial können auch Heteroaromaten wie insbesondere Triazole eingesetzt werden, gegebenenfalls auch Pyrrole, Imidazole, Triazole, Pyridine, Pyrimidine, Pyridazine Chinoxaline, Pyrazino-chinoxaline und dergleichen. Die Heteroaromaten sind vorzugsweise substituiert, insbesondere Aryl-substituiert, beispielsweise Phenyl- oder Naphthyl-substituiert. Insbesondere kann untenstehendes Triazol als Matrixmaterial eingesetzt werden.

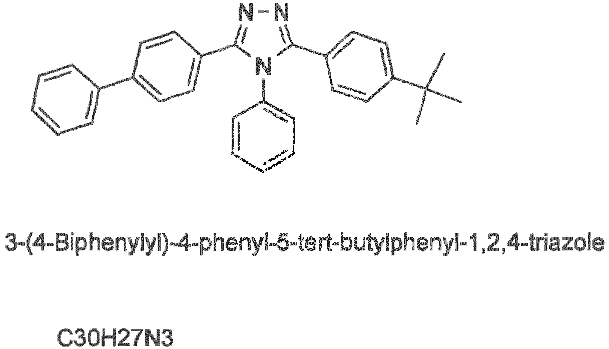

Vorzugsweise besteht das verwendete Matrixmaterial vollständig aus einem Metallphthalocyanin-Komplex, insbesondere ZnPc, einem Porphyrin-Komplex, oder einem Buckminster-Fulleren, insbesondere Fulleren C60.

Es versteht sich, dass die genannten Matrixmaterialien auch untereinander oder mit anderen Materialien gemischt im Rahmen der Erfindung einsetzbar sind. Es versteht sich, dass auch geeignete andere organische Matrixmaterialien verwendet werden können, die halbleitende Eigenschaften aufweisen.

Besonders bevorzugt werden erfindungsgemäß Matrixmaterialien eingesetzt, die ein Reduktionspotential von kleiner als -1V vs. Fc/Fc⁺, bevorzugt kleiner als -1,7V vs. Fc/Fc⁺, insbesondere kleiner als -2,3V vs. Fc/Fc⁺ zeigen. Die Angabe Fc/Fc⁺ bezieht sich auf das Redoxpaar Ferrocen/Ferrocenium, das als Referenz in einer elektrochemischen Potentialbestimmung, zum Beispiel Zyclovoltammetrie, eingesetzt wird.

### Ausführungsbeispiele

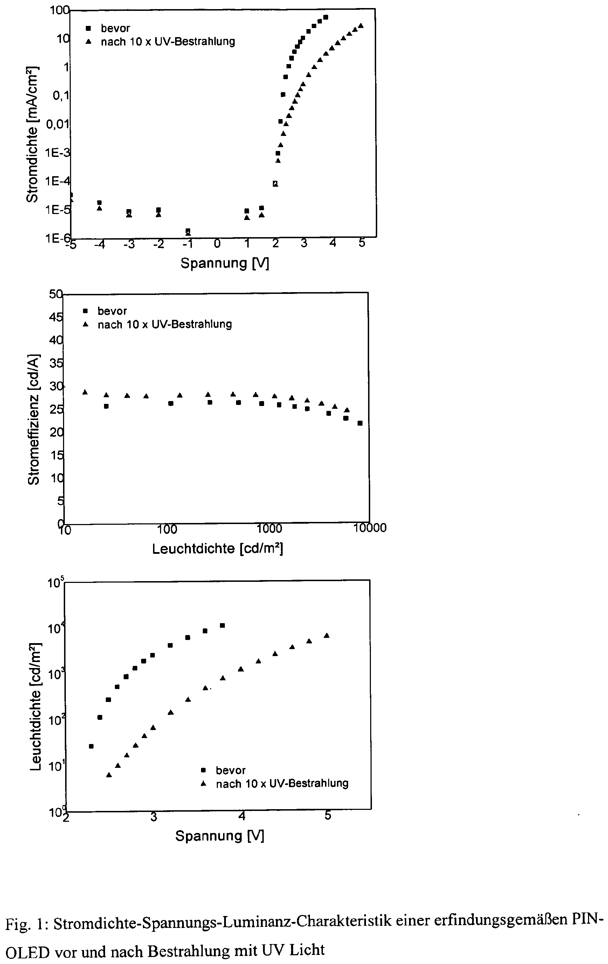

Im folgenden werden beispielhafte Ausführungsformen des erfindungsgemäßen Verfahren zur Herstellung eines Halbleiterbauelements angegeben unter Verweis auf die beiliegende Figur 1, die Kenndaten einer gemäß Beispiel 2 hergestellten organischen Leuchtdiode wiedergibt.

### Beispiel 1: Photostrukturierung durch Aktivierung

Zur Herstellung eines erfindungsgemäßen Bauelements, hier einer OLED, wurden die organischen Schichten sowie die Metallschicht mittels thermischer Verdampfung auf ITObeschichtetem Glas in einem Ultrahochvakuumsystem bei einem Druck von ca. 10⁻⁷ mbar abgeschieden, ohne dass das Vakuum während der Herstellung unterbrochen wurde. Die Abscheideraten und -dicken wurden mittels Schwingquarzmonitoren kontrolliert. Die Herstellung der OLED erfolgte unter Lichtabschluss. Zu diesem Zweck wurde Ytterbiumdampf (s. unten) bei der Metallabscheidung mit Hilfe eines Graphitrohrs Richtung Substrat umgelenkt, um Lichteinfall aus dem erhitzten Metalltiegel zu vermeiden.

Die erfindungsgemäße OLED weist folgenden Aufbau auf:
1.0) 90 nm ITO
1.1) 50 nm
   2,2',7,7'-Tetrakis-(N,N-di-methylphenylamino)-9,9'-spirobifluoren dotiert mit 4 % 2-(6-Dicyanomethylen-1,3,4,5,7,8-hexafluoro-6H-naphtalen-2-ylidene)-malononitril
1.2) 10 nm NPB
1.3) 20 nm NPB dotiert mit 15 % Bis(1-phenylisoquinoline)-(acetylacetonat) iridium (III).
1.4) 10 nm 2,4,7,9-Tetraphenyl-phenanthrolin
1.5) 60 nm 2,4,7,9-Tetraphenyl-phenanthrolin dotiert mit 10 % 10c,10c'-Bis(8,9-dimethyl-2,3,5,6-tetrahydro-1H,4H-3a,6a,10b-triazafluoranthenyl)
1.6) 100 nm Ytterbium

Hierbei handelt es sich um eine rote OLED mit einem Emissionsmaximum bei 620 nm.

Unmittelbar nach der Prozessierung wurde eine Spannung von 4V an die Probe angelegt. Es gab bei dieser Spannung nur eine sehr schwache Lichtemission unterhalb 10 cd/m². Nach der Prozessierung und während der Messung wurde die OLED ausschließlich gelb-orangen Umgebungslicht ausgesetzt. Anschließend wurde die OLED zur Hälfte lichtdicht abgedeckt. Die andere Hälfte wurde für eine Dauer von einer Minute mit blauem Licht (Peak-Wellenlänge ca. 450 nm) bestrahlt. Im Anschluss wurde die lichtdichte Abdeckung entfernt. Die OLED wurde erneut vermessen. Der belichtete Teil leuchtete nun mit einer Helligkeit von 1000 cd/m2 bei einer Spannung von 3,9 V. Die Stromeffizienz bei dieser Helligkeit beträgt 4 cd/A. Der unbelichtete Teil dagegen glimmt weiterhin nur sehr schwach.

### nicht beanspruchtes

### Beispiel 2: Photostrukturierung durch Deaktivierung (nicht erfindungsgemäß)

Die hier eingesetzte erfindungsgemäße OLED weist folgenden Aufbau auf:
1) 50 nm 2,2',7,7'-Tetrakis-(N,N-di-methylphenylamino)-9,9'-spirobifluoren dotiert mit 4 % F4-TCNQ
2) 10 nm NPB
3) 20 nm NPB dotiert mit 10 % Iridium (III) bis(2-methyldibenzo[f,h]quinoxaline) (acetylacetonat)
4) 10 nm BPhen
5) 60 nm BPhen dotiert mit Cs
6) 100 nm Aluminium

Hierbei handelt es sich um eine rote OLED mit einem Emissionsmaximum bei 610 nm. Die OLED erreicht eine Helligkeit von 270 cd/m², was einer typischen Monitorhelligkeit entspricht, bei einer Spannung von 2,5 V. Die Stromeffizienz bei dieser Helligkeit beträgt 26 cd/A.

### NPD = N,N'-Bis(naphthalin-1-yl)-N,N'-bis(phenyl)benzidin

Wird diese OLED für eine Dauer von 30 Minuten mit UV-Licht einer Quecksilberdampflampe (1000 W, 50 cm Abstand zwischen Lampe und Probe) belichtet, so bleibt die Stromeffizienz erhalten, die Strom-Spannungs-Kennlinie dagegen flacht deutlich ab. So wird nun bei einer angelegten Spannung von 2,5 V nur noch eine Luminanz von 5 cd/m² erreicht. Bei selber Spannung wurde also die Lichtemission um einen Faktor von über 50 reduziert.

Figur 1 gibt die Kenndaten einer gemäß Beispiel 2 hergestellten organischen Leuchtdiode wieder. Am aussagekräftigsten sind dabei das erste und das dritte Teilschema. Deutlich ist zu erkennen, daß bei einer gegebenen Betriebsspannung (zum Beispiel 3V) die Strom- bzw. Leuchtdichte einer deaktivierten OLED um mindestens 1,5 Größenordnungen geringer ist als zuvor.

Die fertigen Bauelemente können beispielsweise durch UV-Filter davor geschützt werden, daß das eingeprägte Bild ausbleicht.

Prinzipiell sind die Verfahren unter Einsatz einer Aktivierung bzw. einer Deaktivierung im Kern identisch; die Produkte weisen lediglich ein invertiertes Leuchtverhalten auf. Der Einsatz der Deaktivierung könnte den Vorteil haben, daß während der OLED-Prozessierung keine Vorsichtsmaßnahmen bezüglich des Lichtausschlusses, etc. berücksichtigt werden müßten.

Das erfmdungsgemäße Verfahren mit Aktivierung kann beispielsweise für die Herstellung von Bauteilen, wie flächigen OLED-Anzeigen eingesetzt werden, in die nach Fertigstellung des organischen Schichtstapels mit Hilfe einer UV-Bestrahlung durch eine Belichtungsmaske hindurch ein beliebiges Muster "eingeprägt" wird. Nur Teilbereiche der Anzeige leuchten dann im Betrieb mit voller Helligkeit. Dieses Muster kann u.a. ein Firmenlogo, ein Hinweisschild oder eine dekorative Applikation sein.

Weitere Anwendungsmöglichkeiten sind ohne Einschränkung hierauf die folgenden:
Tags: Leuchtende Preisangaben in Supermärkten; Namensschilder an Türklingeln; Einprägen von Information ("Barcodes"), die bei Bedarf durch einen Induktionsstrom zum Leuchten gebracht werden und damit zum Auslesen bereit sind (als Ersatz für heute übliche Sicherheitshologramme; der technisch höhere Aufwand für OLEDs erschwert Fälschungen).

Plakate: Frei und rasch gestaltbare Reklametafeln und Leuchtzüge für Schaufenster.

Leuchtmittel für Wohnräume: Eine vollkommen frei definierbare Leuchtkulisse kann realisiert werden, inklusive hellerer und dunklerer Bereiche oder durch Einprägen von Mustern ("Leuchttapete").

Hervorzuheben ist die erfindungsgemäße Möglichkeit zur variablen Generierung von Ladungsträgern in Abhängigkeit von der Bestrahlungsdauer oder der Bestrahlungsintensität. Die Verwendung einer Maske mit starken bzw. geringen UV-Filtereigenschaften oder eine kurze bzw. lange Belichtung mittels Laserlithographie erzeugt wenige bzw. viele Ladungsträger. Als Konsequenz daraus ergeben sich dunkler und heller leuchtende Bereiche der OLED. Somit sind auch Intensitätsverläufe in der Strahlung einer OLED realisierbar. Denkbar ist auch ein individuelles, freihändiges Beschreiben einer zu aktivierenden OLED mit einer geeigneten, tragbaren Lichtquelle.

Prinzipiell kann der Aktivierungsmechanismus auch für Polymer-OLEDs verwendet werden, indem geeignete Dotanden der Polymerlösung beigemischt und dann zusammen aufgeschleudert werden. Die Dotierung erfolgt dann wie oben beschrieben.

Die in der vorstehenden Beschreibung, in den Ansprüchen und der Zeichnung offenbarten Merkmale der Erfindung können sowohl einzeln als auch in jeder beliebigen Kombination für die Verwirklichung der Erfindung in ihren verschiedenen Ausführungsformen wesentlich sein.

## Patentansprüche

1. Verfahren zur räumlichen Strukturierung der Leuchtdichte von lichtemittierenden organischen Halbleiterbauelementen, umfassend die Schritte:
(i) Herstellen eines lichtemittierenden organischen Bauelements umfassend eine elektronenleitende Schicht aus organischem Matrixmaterial und homogen darin eingebetteten n-Dotandenprecursorn;
(iia) Bestrahlen eines oder mehrerer Teilbereiche des Bauelements zur Spaltung der n-Dotandenprecursor im bestrahlten Bereich in n-Dotanden
wobei der n-Dotand ein heterocyclisches Radikal oder Diradikal ist und der n-Dotandenprecursor ein Dimer eines heterocyclischen Radikals oder Diradikals, ein Oligomer eines heterocyclischen Radikals oder Diradikals, ein Polymer eines heterocyclischen Radikals oder Diradikals, eine Dispiroverbindung eines heterocyclischen Radikals oder Diradikals oder ein Polycyclus eines heterocyclischen Diradikals ist und die Strukturen der n-Dotandenprecursor ausgewählt werden aus den folgenden Formeln 2, 4 und 6 und/oder n-Dotanden ausgewählt werden aus den folgenden Formeln 1, 3, 5, 7, 8a, 8b, 8c, 10 und 11 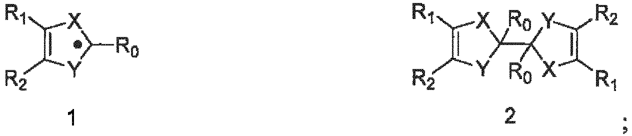 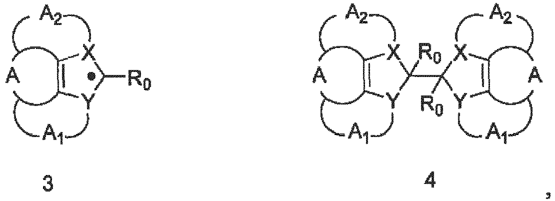 wobei die Strukturen 3 und 4 eine oder mehrere cyclische Verknüpfungen A und/oder A₁ und/oder A₂ aufweisen, wobei A, A₁ und A₂ carbocyclische, heterocyclische und/oder polycyclische Ringsysteme sein können, die substituiert oder unsubstituiert sein können; 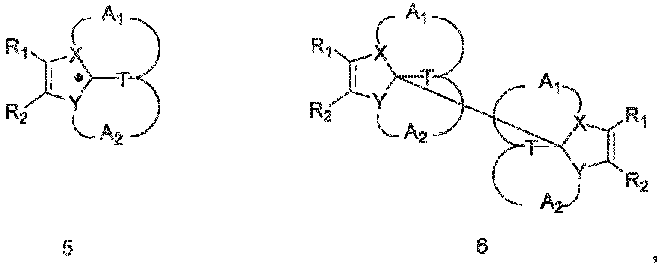 wobei A₁ und A₂ einzeln oder gemeinsam vorliegen können und A₁ und A₂ wie für Strukturen 3 und 4 definiert sind und T = CR₂₂, CR₂₂R₂₃, N, NR₂₁, O oder S ist; 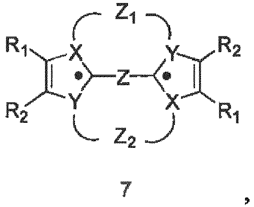 wobei Struktur 7 eine oder mehrere Brückenverbindungen Z und/oder Z₁ und/oder Z₂ aufweist, und Z, Z₁ und Z₂ unabhängig ausgewählt sein können aus Alkyl, Alkenyl, Alkinyl, Cycloalkyl, Sililyl; Alkylsililyl, Diazo, Disulfid, Heterocycloalkyl, Heterocyclyl, Piperazinyl, Dialkylether, Polyether, primärem Alkylamin, Arylamin und Polyamin, Aryl und Heteroaryl; 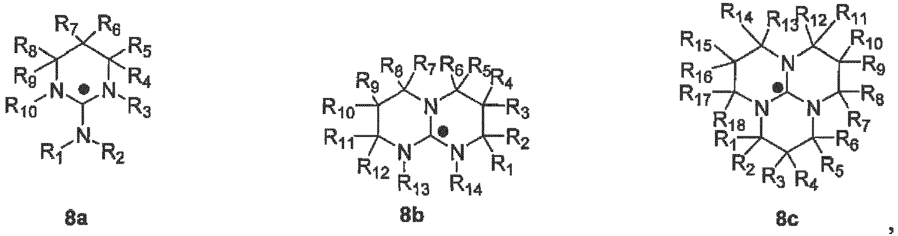 wobei in den Strukturen 8a - 8c die Ringgröße je Heterocyclus von 5 - 7 Atomen variieren kann; 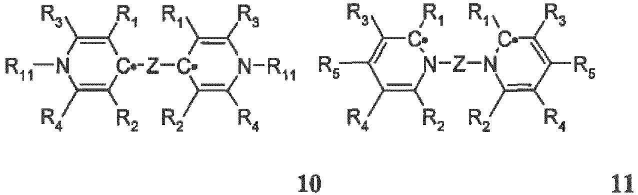 wobei X, Y = O, S, N, NR₂₁, P, oder PR₂₁ ist; Z wie oben definiert ist; R₀₋₁₉, R₂₁, R₂₂ und R₂₃ unabhängig ausgewählt sind aus, substituiert oder unsubstituiert, Aryl, Heteroaryl, Heterocyclyl, Diarylamin, Diheteroarylamin, Dialkylamin, Heteroarylalkylamin, Arylalkylamin, H, Cycloalkyl, Halogencycloalkyl, Heterocycloalkyl, Alkyl, Alkenyl, Alkinyl, Trialkylsilyl, Triarylsilyl, Halogen, Styryl, Alkoxy, Aryloxy, Thioalkoxy, Thioaryloxy, Sililyl und Trialkylsilylalkinyl, oder R₀₋₁₉, R₂₁, R₂₂ und R₂₃, allein oder in Kombination, Teil eines Ringsystems, (hetero)aliphatisch oder (hetero)aromatisch, sind,
wobei das Bestrahlen in Schritt (iia) durchgeführt wird mit elektromagnetischer Strahlung, und
wobei nicht das gesamte Bauelement homogen bestrahlt wird.

2. Verfahren nach Anspruch 1, **dadurch gekennzeichnet, dass** das Bestrahlen in Schritt (i-ia) durch Abdeckung der nicht zu bestrahlenden Teilbereiche durchgeführt wird.

3. Verfahren nach Anspruch 2, **dadurch gekennzeichnet, dass** das Bestrahlen in Schritt (i-ia) durch Anordnung einer oder mehrerer Schattenmasken auf dem Bauelement durchgeführt wird.

4. Verfahren nach Anspruch 1, **dadurch gekennzeichnet, dass** das Bestrahlen mit sichtbarem Licht, UV-Licht oder IR-Licht durchgeführt wird.

5. Verfahren nach Anspruch 4, **dadurch gekennzeichnet, dass** das Bestrahlen mit Laserlicht durchgeführt wird.

6. Verfahren nach einem der vorangehenden Ansprüche, **dadurch gekennzeichnet, dass** A, A₁ und A₂ ausgewählt werden aus substituierten oder nicht-substituierten, aromatischen und heteroaromatischen Ringsystemen, vorzugsweise Benzo-, Naphtho-, Thiophen-, Furan-, Thiazol-, Imidazol-, Oxazol-, Thiadiazol-, Pyrazin-, Thiopyran-, Dithiin-, Phthalsäureimid- und Dithiazol-Resten, wobei eine oder mehrere Substituenten vorliegen können, die ausgewählt sind aus R₀ - R₁₉, R₂₁, R₂₂ und R₂₃.

7. Verfahren nach einem der vorangehenden Ansprüche, **dadurch gekennzeichnet, dass** Z, Z₁ und Z₂ ausgewählt werden aus Piperazinyl und Alkyl bzw. Cycloalkyl.

8. Verfahren nach einem der vorangehenden Ansprüche, **dadurch gekennzeichnet, dass** der Dotand ausgewählt wird aus den folgenden Strukturen: 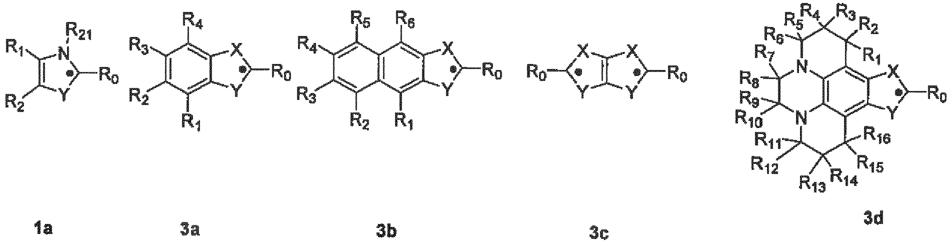 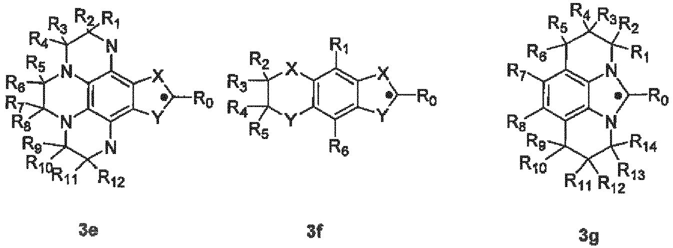 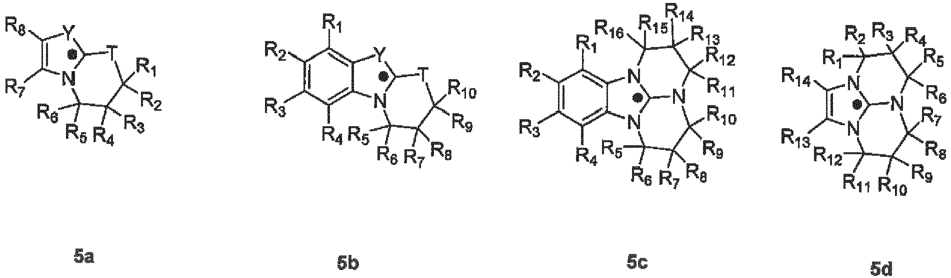 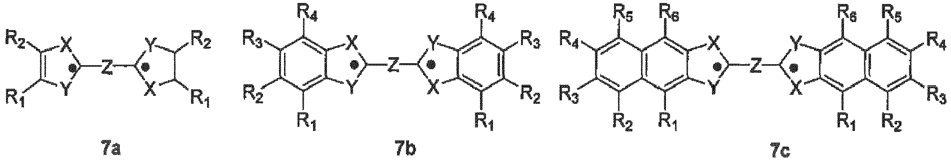 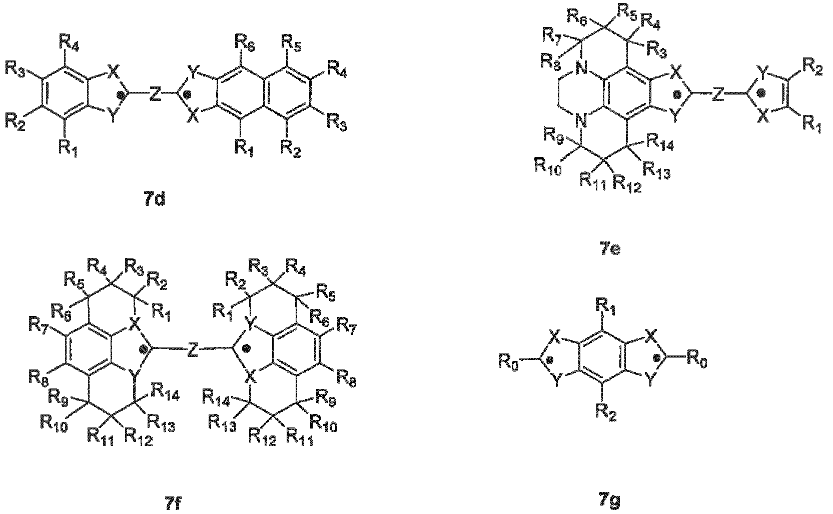 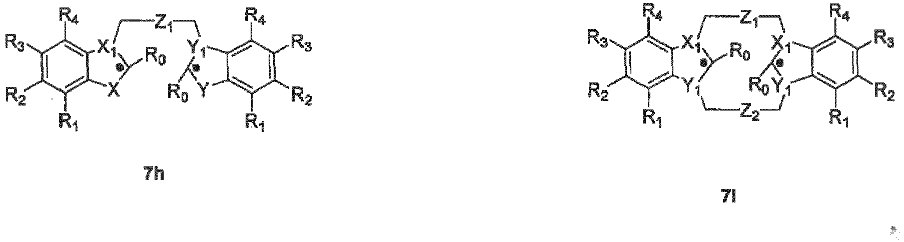 wobei X₁, Y₁ = N oder P ist.

9. Verfahren nach einem der vorangehenden Ansprüche, **dadurch gekennzeichnet, dass** R₀₋₁₉, R₂₁, R₂₂ und R₂₃ ausgewählt werden aus, substituiert oder nicht substituiert Phenyl, Biphenyl, Naphthyl, Anthranyl, Thienyl, Imidazolyl, Pyrrolyl, Thiazolyl, Oxazolyl, Thiadiazolyl, Piperidyl, Pyrrolidyl, Morpholyl und Thiomorpholyl.

10. Verfahren nach einem der vorangehenden Ansprüche, **dadurch gekennzeichnet, dass** R₀₋₁₉, R₂₁, R₂₂ und R₂₃ ausgewählt werden aus, Alkyl, Cykloalkyl, Dialkylamin, Diarylamin, Alkoxy, Aryloxy, Thioaryl, Thioalkoxy, Perfluoralkyl.

11. Verfahren nach einem der vorangehenden Ansprüche, **dadurch gekennzeichnet, dass** der Polycyclus ein Tricyclus ist.

12. Verfahren nach einem der vorangehenden Ansprüche, **dadurch gekennzeichnet, dass** zur elektronenleitenden Schicht Photoinitiatoren zugesetzt werden, vorzugsweise Ketone, wie Phenone.

## Claims

1. A method for spatially structuring the luminance of light-emitting organic semiconductor components, comprising the steps:
(i) producing a light-emitting organic component comprising an electron-conducting layer of organic matrix material and homogeneously embedded n-dopant precursors therein;
(iia) irradiating one or more partial regions of the component in the irradiated region in n-dopants for cleaving the n-dopant precursors
wherein the n-dopant is a heterocyclic radical or diradical and the n-dopant precursor is a dimer of a heterocyclic radical or diradical, an oligomer of a heterocyclic radical or diradical, a polymer of a heterocyclic radical or diradical, a dispiro compound of a heterocyclic radical or diradical or a polycycle of a heterocyclic diradical and the structures of the n-dopant precursors are selected from the following formulas 2, 4 and 6 and/or n-dopants are selected from the following formulas 1, 3, 5, 7, 8a, 8b, 8c, 10 and 11 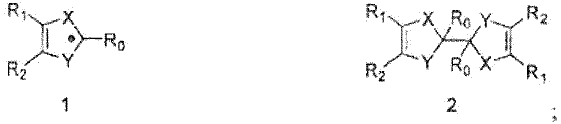 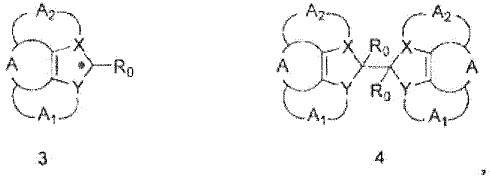 wherein the structures 3 and 4 have one or more cyclic linkages A and/or A₁ and/or A₂, wherein A, A₁ and A₂ can be carbocyclic, heterocyclic and/or polycyclic ring systems which can be substituted or unsubstituted; 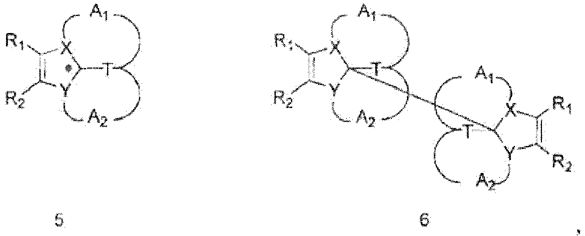 wherein A₁ and A₂ can be single or shared and A₁ and A₂ are as defined for structures 3 and 4 and T = CR₂₂, CR₂₂R₂₃, N, NR₂₁, O or S; 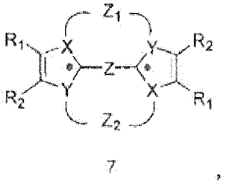 wherein structure 7 has one or more bridging compounds Z and/or Z₁ and/or Z₂, and Z, Z₁ and Z₂ can be independently selected from alkyl, alkenyl, alkynyl, cycloalkyl, silylyl; alkylsilyl, diazo, disulfide, heterocycloalkyl, heterocyclyl, piperazinyl, dialkyl ether, polyether, primary alkylamine, arylamine and polyamine, aryl and heteroaryl; 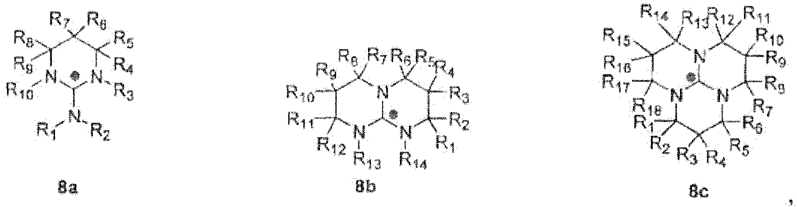 wherein in the structures 8a-8c, the ring size per heterocycle can vary from 5 -7 atoms; 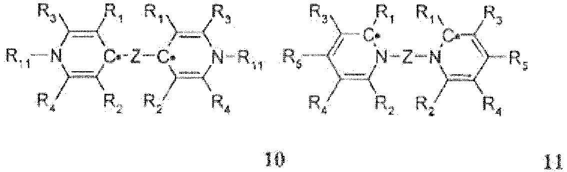 wherein X, Y = O, S, N, NR₂₁, P, or PR₂₁; Z is as defined above; R₀₋₁₉, R₂₁, R₂₂ and R₂₃ are independently selected from, substituted or unsubstituted, aryl, heteroaryl, heterocyclyl, diarylamine, diheteroarylamine, dialkylamine, heteroarylalkylamine, arylalkylamine, H, cycloalkyl, halocycloalkyl, heterocycloalkyl, alkyl, alkenyl, alkynyl, trialkylsilyl, triarylsilyl, halogen, styryl, alkoxy, aryloxy, thioalkoxy, thioaryloxy, silylyl and trialkylsilylalkynyl, or R₀₋₁₉, R₂₁, R₂₂ and R₂₃, alone or in combination, are part of a ring system, (hetereo)aliphatic or (hetero)aromatic,
wherein the irradiation in step (iia) is performed using electromagnetic radiation, and
wherein not all of the component is homogeneously irradiated.

2. The method according to claim 1, **characterized in that** the irradiation in step (iia) is performed by covering the non-irradiated partial regions.

3. The method according to claim 2, **characterized in that** the irradiation in step (iia) is performed by arranging one or more shadow masks on the component.

4. The method according to claim 1, **characterized in that** the irradiation is performed using visible light, UV light or IR light.

5. The method according to claim 4, **characterized in that** the irradiation is performed using laser light.

6. The method according to any one of the preceding claims, **characterized in that** A, A₁ and A₂ are selected from substituted or unsubstituted, aromatic and heteroaromatic ring systems, preferably benzo, naphtho, thiophene, furan, thiazole, imidazole, oxazole, thiadiazole, pyrazine, thiopyrane, dithiine, phthalic acid imide and dithiazole radicals, wherein one or more substituents can be present, which are selected from R₀-R₁₉, R₂₁, R₂₂ and R₂₃.

7. The method according to any one of the preceding claims, **characterized in that** Z, Z₁ and Z₂ are selected from piperazinyl and alkyl or cycloalkyl.

8. The method according to any one of the preceding claims, **characterized in that** the dopant is selected from the following structures: 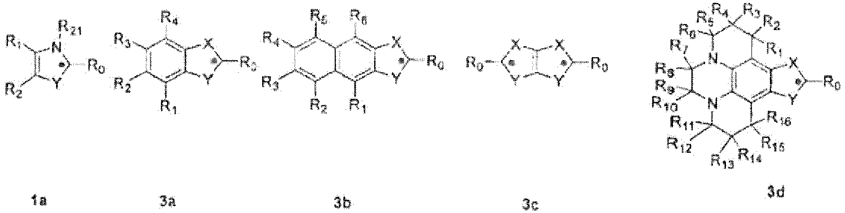 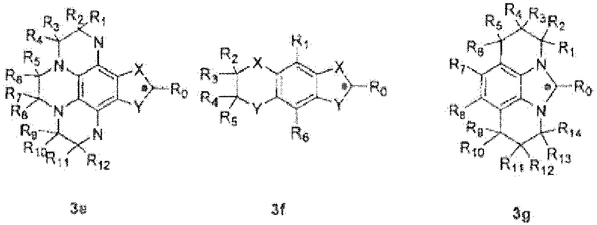 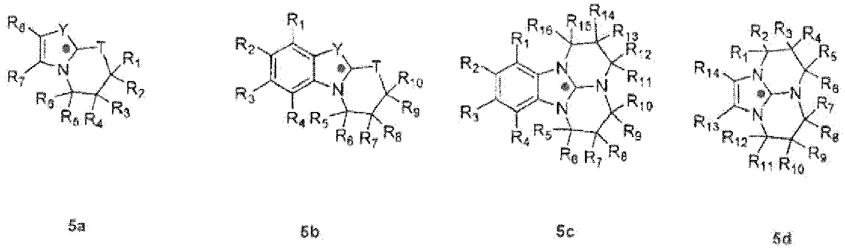 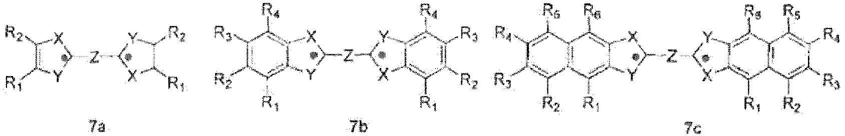 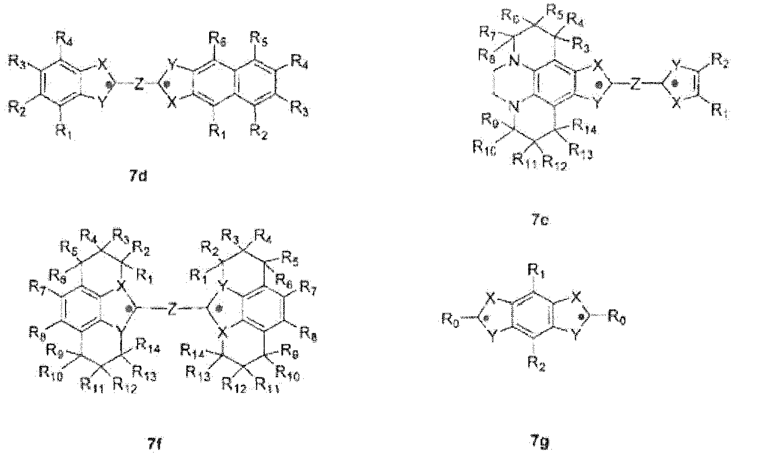 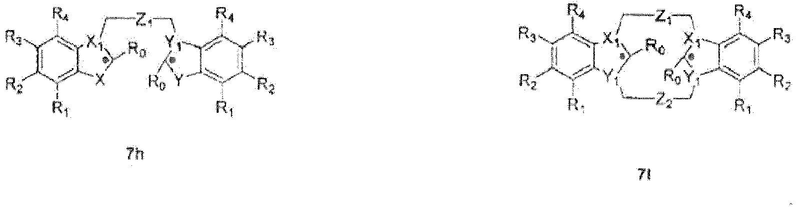 wherein X₁, Y₁ = N or P.

9. The method according to any one of the preceding claims, **characterized in that** R₀₋₁₉, R₂₁, R₂₂ and R₂₃ are selected from, substituted or unsubstituted phenyl, biphenyl, naphthyl, anthranyl, thienyl, imidazolyl, pyrrolyl, thiazolyl, oxazolyl, thiadiazolyl, piperidyl, pyrrolidyl, morpholyl and thiomorpholyl.

10. The method according to any one of the preceding claims, **characterized in that** R₀₋₁₉, R₂₁, R₂₂ and R₂₃ are selected from, alkyl, cycloalkyl, dialkylamine, diarylamine, alkoxy, aryloxy, thioaryl, thioalkoxy, perfluoroalkyl.

11. The method according to any one of the preceding claims, **characterized in that** the polycycle is a tricycle.

12. The method according to any one of the preceding claims, **characterized in that** photoinitiators, preferably ketones, such as phenones, are added to the electron-conducting layer.

## Revendications

1. Procédé, destiné à la structuration spatiale de la luminance de composants organiques à semi-conducteur émetteurs de lumière, comprenant les étapes consistant à :
(i) fabriquer un composant organique à semi-conducteur émetteur de lumière, comprenant une couche conductrice électronique en une matière matricielle organique et des précurseurs de n-dopants incorporés de manière homogène dans celle-ci ;
(iia) irradier une ou plusieurs zones partielles du composant pour scinder en n-dopants le précurseur de n-dopants dans la zone irradiée
le n-dopant étant un radical ou un diradical hétérocyclique et le précurseur de n-dopants étant un dimère d'un radical ou diradical hétérocyclique, un oligomère d'un radical ou diradical hétérocyclique, un polymère d'un radical ou diradical hétérocyclique, une liaison dispiro d'un radical ou diradical hétérocyclique ou un polycycle d'un diradical hétérocyclique et les structures des précurseurs de n-dopants étant sélectionnées parmi les formules 2, 4 et 6 suivantes et/ou des n-dopants étant sélectionnés parmi les formules 1, 3, 5, 7, 8a, 8b, 8c, 10 et 11 suivantes 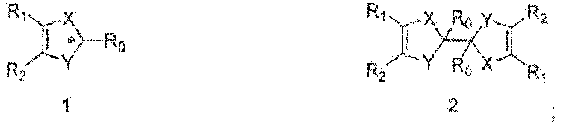 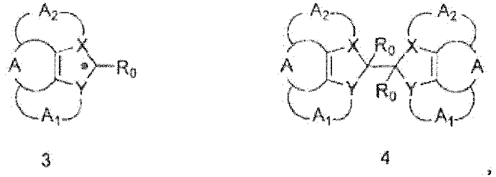 les structures 3 et 4 et comportant une ou plusieurs liaisons cycliques A et/ou A₁ et/ou A₂, A, A₁ et A₂ pouvant être des systèmes cycliques carbocycliques, hétérocycliques et/ou polycycliques, qui peuvent être substitués ou non substitués ; 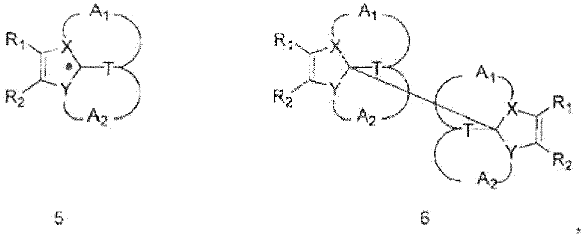 A₁ et A₂ pouvant se présenter individuellement ou conjointement et A₁ et A₂ étant définis comme pour des structures 3 et 4 et T étant = à CR₂₂, à CR₂₂R₂₃, à N, à NR₂₁, à 0 ou étant S ; 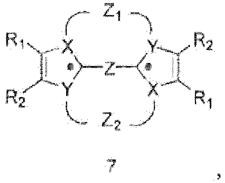 la structure 7 comportant un ou plusieurs chaînons Z et/ou Z₁ et/ou Z₂, et Z, Z₁ et Z₂ pouvant être sélectionnés indépendamment parmi un groupe alkyle, alkényle, alkinyle, cyclo-alkyle, sililyle ; alkylsililyle, diazo, disulfure, hétérocycloalkyle, hétérocyclyle, pipérazinyle, dialkyléther, polyéther, des alkylamines primaires, un groupe arylamine et polyamine, aryle et hétéroroaryle ; 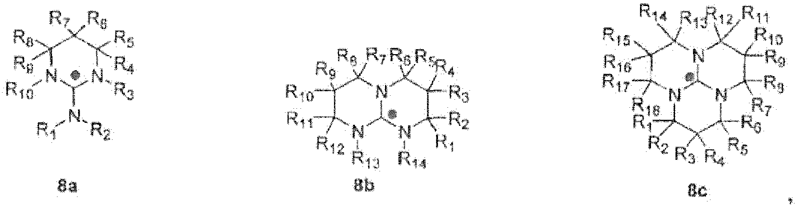 dans les structures 8a à 8c, la taille du cycle pouvant varier de 5 à 7 atomes par hétérocycle ; 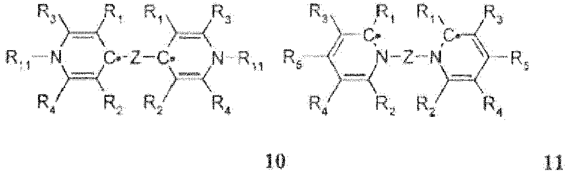 X, Y étant = à O, S, N, NR₂₁, P, ou à PR₂₁ ; Z étant défini comme ci-dessus ; R₀₋₁₉, R₂₁, R₂₂ et R₂₃ étant sélectionnés indépendamment, en étant substitués ou non substitués parmi un groupe aryle, hétéroaryle, hétérocyclyle, diarylamine, dihétéroarylamine, dialkylamine, hétéroarylalkylamine, arylalkylamine, H, cyclo-alkyle, halogénocyclo-alkyle, hétérocyclo-alkyle, alkyle, alkényle, alkinyle, trialkylsilyle, triarylsilyle, halogène, styryle, alkoxy, aryloxy, thioalkoxy, thioaryloxy, sililyle et trialkylsilylalkinyle, ou R₀₋₁₉, R₂₁, R₂₂ et R₂₃, seuls ou en association, étant une partie d'un système cyclique, (hétéro)aliphatique ou (hétéro)aromatique,
l'irradiation étant réalisée dans l'étape (iia) par rayonnement électromagnétique, et
la totalité du composant n'étant pas irradiée de manière homogène.

2. Procédé selon la revendication 1, **caractérisé en ce que** l'irradiation dans l'étape (iia) est réalisée par recouvrement des zones partielles qui ne doivent pas être irradiées.

3. Procédé selon la revendication 2, **caractérisé en ce que** l'irradiation dans l'étape (iia) est réalisée par placement d'un ou de plusieurs masques d'ombrage sur le composant.

4. Procédé selon la revendication 1, **caractérisé en ce que** l'irradiation est réalisée à la lumière visible, à la lumière UV ou à la lumière IR.

5. Procédé selon la revendication 4, **caractérisé en ce que** l'irradiation est réalisée à la lumière laser.

6. Procédé selon l'une quelconque des revendications précédentes, **caractérisé en ce que** A, A₁ et A₂ sont sélectionnés parmi des systèmes cycliques substitués ou non substitués, aromatiques et hétéro-aromatiques, de préférence des restes benzo, naphta, thiophène, furane, thiazole, imidazole, oxazole, thiadiazole, pyrazine, thiopyrane, dithiine, imide d'acide phtalique-et dithiazole, un ou plusieurs substituants, qui sont sélectionnés parmi R₀ - R₁₉, R₂₁, R₂₂ et R₂₃ pouvant être présents.

7. Procédé selon l'une quelconque des revendications précédentes, **caractérisé en ce que** Z, Z₁ et Z₂ sont sélectionnés parmi un groupe pipérazinyle et alkyle ou cyclo-alkyle.

8. Procédé selon l'une quelconque des revendications précédentes, **caractérisé en ce que** le dopant est sélectionné parmi les structures suivantes : 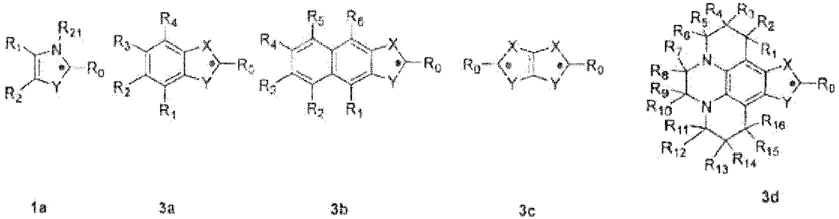 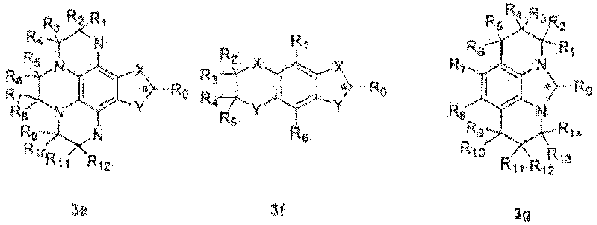 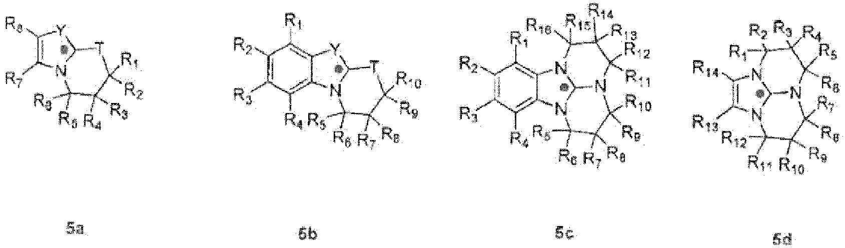 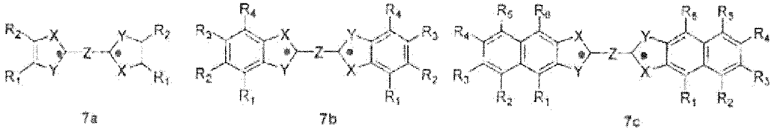 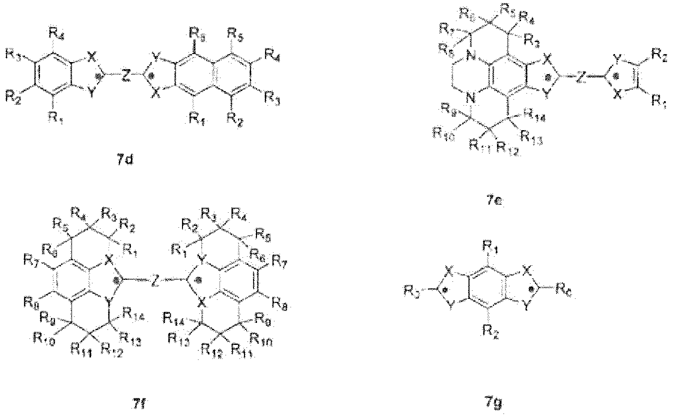 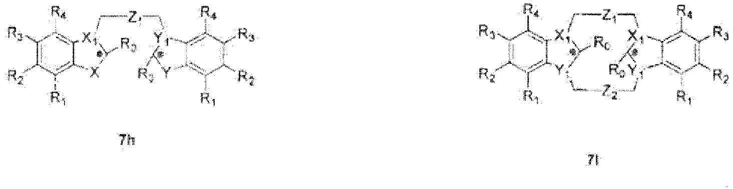 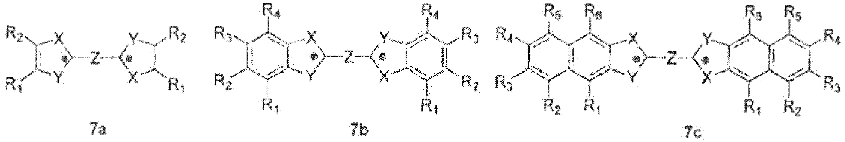 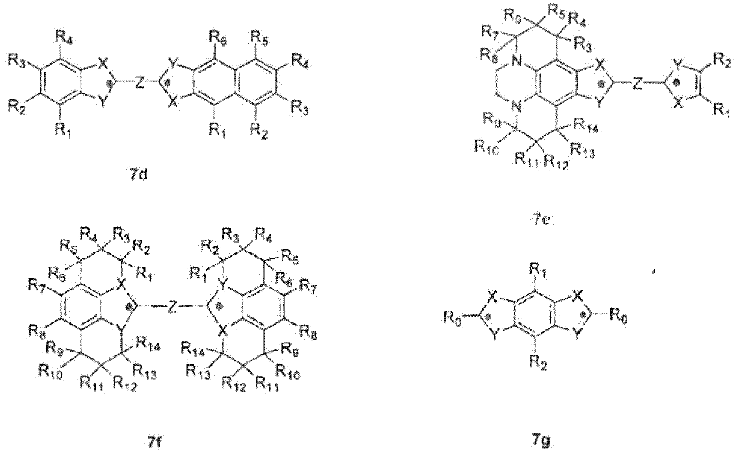 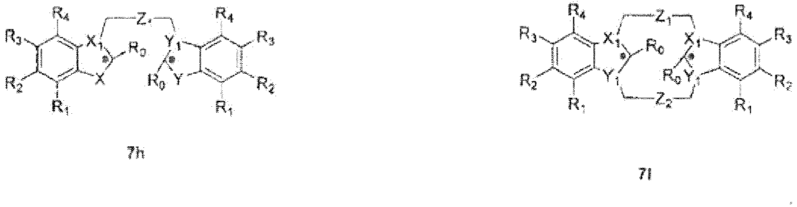 X₁, Y₁ étant = à N ou P.

9. Procédé selon l'une quelconque des revendications précédentes, **caractérisé en ce que** R₀₋₁₉, R₂₁, R₂₂ et R₂₃ sont sélectionnés, substitués ou non substitués parmi un groupe phényle, biphényle, naphtyle, anthranyle, thiényle, imidazolyle, pyrrolyle, thiazolyle, oxazolyle, thiadiazolyle, pipéridyle, pyrrolidyle, morpholyle et thiomorpholyle.

10. Procédé selon l'une quelconque des revendications précédentes, **caractérisé en ce que** R₀₋₁₉, R₂₁, R₂₂ et R₂₃ sont sélectionnés parmi un groupe phényle, alkyle, cyclo-alkyle, dialkylamine, diarylamine, alcoxy, aryloxy, thioaryle, thioalcoxy, perfluoroalkyle.

11. Procédé selon l'une quelconque des revendications précédentes, **caractérisé en ce que** le polycycle est un tricycle.

12. Procédé selon l'une quelconque des revendications précédentes, **caractérisé en ce qu'**à la couche conductrice électronique on ajoute photo-initiateurs, de préférence des cétones, comme des phénones.
